Europäisches Patentamt

(19) European Patent Office

Office européen des brevets

(11) Numéro de publication: **0 204 633**
**B1**

(12) **FASCICULE DE BREVET EUROPEEN**

(45) Date de publication du fascicule du brevet: **19.09.90**

(21) Numéro de dépôt: **86401181.2**

(22) Date de dépôt: **03.06.86**

(51) Int. Cl.⁵: **G 09 G 3/18, H 05 K 7/10**

(54) **Dispositif perfectionné d'interconnexion pour dispositif d'affichage statique du type écran plat, procédé de fabrication et boîte à lumière incorporant ce dispositif.**

(30) Priorité: **05.06.85 FR 8508468**

(43) Date de publication de la demande:
**10.12.86 Bulletin 86/50**

(45) Mention de la délivrance du brevet:
**19.09.90 Bulletin 90/38**

(84) Etats contractants désignés:
**DE FR GB IT**

(56) Documents cités:
**EP-A-0 130 498**
**GB-A-2 122 013**
**US-A-4 008 938**

**SOLID-STATE TECHNOLOGY, janvier 1979, pages 87-93, Washington, US; J. MARSHALL et al.: "Solder bump interconnected, multiple chip, thick film hybrid for 40-character alphanumeric LCD application"**

**TECHNICAL DIGEST - WESTERN ELECTRIC, no. 67, juillet 1982, pages 1,2, New York, US; W.D. APGAR: "Back lighting liquid crystal displays with light-emitting diodes"**

(73) Titulaire: **JAEGER**
**2, rue Baudin**
**F-92303 Levallois-Perret (FR)**

(72) Inventeur: **Bezard, Jean-Jacques**
**11, rue des Bois aux Petits-Chênes**
**F-78400 Chatou (FR)**
Inventeur: **Chapotot, Michel**
**26, rue Eugénie**
**F-95150 Taverny (FR)**

(74) Mandataire: **Martin, Jean-Jacques et al**
**Cabinet REGIMBEAU 26, Avenue Kléber**
**F-75116 Paris (FR)**

## Description

La présente invention concerne les systèmes incorporant des dispositifs d'affichage statique du type écran plat, en particulier des afficheurs à cristaux liquides.

La présente invention concerne plus précisément un système afficheur incorporant un dispositif perfectionné d'interconnexion entre un dispositif d'affichage statique du type écran plat et des moyens d'alimentation électrique de celui-ci et un procédé de fabrication de ce système.

D'une façon générale, les dispositifs d'afkichage du type écran plat, sont formés d'au moins deux plaques transparentes parallèles, le plus souvent en verre, scellées hermétiquement sur le pourtour et entre lesquelles sont disposées des couches de matériau électro-optique.

Les plaques précitées sont munies sur leur surface interne en regard d'électrodes de commande.

Le matériau électro-optique disposé entre les plaques change d'aspect en émettant un signal optique, au rhythme de l'évolution du signal électrique appliqué entre les électrodes disposées sur les plaques transparentes.

Pour permettre un fonctionnement correct des dispositifs d'affichage type écran plat, en particulier des afficheurs à cristaux liquides, il est nécessaire d'une part d'assurer une immobilisation ferme et précise de l'afficheur, sans sollicitation excessive sur celui-ci dans la mesure où la structure des afficheurs est relativement fragile en raison notamment de la présence des plaques en verre, d'autre part d'assurer une interconnexion fiable et précise entre les électrodes de l'afficheur et les moyens d'alimentation électrique de celui-ci.

Les tentatives de solutions mécaniques au problème ci-dessus posé n'ont jusqu'ici par donné satisfaction.

On a proposé récemment un dispositif de caoutchouc conducteur formé d'un empilement de couches en caoutchouc silicone flexibles alternativement électriquement conductrices et non conductrices, destiné à être placé entre les contacts d'un afficheur à cristaux liquides et un circuit imprimé associé. L'utilisation d'un tel dispositif de caoutchouc conducteur est par exemple décrite dans les documents GB—A—2122-013 et Technical Digest-Western Electric No. 67 Juillet 1982.

Le document GB—A—2122013 décrit ainsi un système comprenant un dispositif d'affichage statique à cristal liquide, un circuit imprimé supportant au moins une pastille de circuit intégré formant circuit pilote disposé en arrière du dispositif d'affichage statique et parallèlement à celui-ci, et des bandes d'interconnexion à base de caoutchouc conducteur.

Le document Technical Digest-Western Electric No. 67 Juillet 1982 décrit un autre système utilisant des moyens d'interconnexion à base de caoutchouc conducteur. Selon ce document le système assez complexe comprend un dispositif d'affichage statique à cristal liquide, un circuit imprimé disposé en arrière du dispositif d'affichage et parallèlement à celui-ci, le circuit imprimé portant une pastille de circuit intégré formant circuit pilote et des diodes LED, des domes en matériau epoxy qui recouvrent les diodes LED, des portions plastiques fixées sur le circuit imprimé, des revêtements réflecteurs déposés sur les portions plastiques, un diffuseur placé sur l'arrière du dispositif d'affichage, un boîtier et deux bandes d'interconnexion à base de caoutchouc conducteur pincées entre le boîtier et les portions plastiques.

Bien que les dispositifs d'interconnexion à base de caoutchouc conducteur aient rendu de grands services, ceux-ci ne donnent pas pleinement satisfaction.

En particulier, les dispositifs souples de connexion précités en caoutchouc silicone sont coûteux.

De plus, leur hauteur nécessairement limitée rend parfois difficile l'implantation de l'afficheur type écran plat et des moyens d'alimentation électrique associés, en particulier lors d'utilisation sous forme d'indicateurs, par exemple pour véhicules automobiles.

Le document US—A—4 008 938 décrit un autre type de dispositif connecteur équivalent destiné à être intercalé entre l'afficheur et le circuit imprimé associé. Ce dispositif comprend un cadre qui porte une pluralité de lamelles de contact incurvées fixées par rivetage à chaud. L'utilisation du dispositif connecteur décrit dans le document US—A—4 008 938 ne donne pas entière satisfaction. Ce dispositif connecteur est coûteux et impose de disposer le circuit imprimé parallèlement à l'afficheur, en arrière de celui-ci.

La présente invention vient maintenant proposer un nouveau dispositif d'interconnexion entre un dispositif d'affichage statique type écran plat et les moyens d'alimentation électrique, en particulier entre un afficheur à cristaux liquides, un circuit pilote et un circuit d'alimentation, qui est à la fois simple, robuste et économique.

Un autre but de la présente invention est de proposer un tel dispositif d'interconnexion, dont la géométrie peut être aisément adaptée en fonction de chaque application particulière, pour faciliter l'implantation du dispositif d'affichage.

Un autre but de la présente invention est de proposer un dispositif d'interconnexion amovible, permettant de remplacer aisément le dispositif d'affichage à cristaux liquides en cas de détérioration de celui-ci.

Enfin, un autre but de la présente invention est de proposer un dispositif d'interconnexion qui puisse aisément être installé sur une chaîne automatique d'assemblage pour permettre la réalisation de grandes séries d'instruments indicateurs.

Ces différents buts sont atteints, selon la présente invention, par un système d'afficheur du type comprenant:

—un dispositif d'affichage statique type écran plat,

—des moyens d'alimentation électrique comportant un circuit pilote pour le dispositif d'affichage, lequel circuit pilote est constitué d'une pastille de circuit intégré et

—un dispositif d'interconnexion entre le dispositif d'affichage statique et les moyens d'alimentation électrique, lequel dispositif d'interconnexion comprend au moins une plaque support généralement plane en matériau relativement rigide et électriquement isolant, sur laquelle sont fixés la pastille du circuit intégré ainsi qu'une série de bandes en matériau électriquement conducteur, les contacts électriques de la pastille de circuit intégré, étant reliés respectivement à des premières extrémités des bandes en matériau électriquement conducteur, caractérisé par le fait que:

—les bandes en matériau électriquement conducteur sont prédécoupés dans une feuille puis fixées sur le support, et présentent à une seconde de leur extrémités des cambrures reposant contre les contacts respectivement associés du dispositif d'affichage,

—le dispositif d'interconnexion comprend au moins deux plaques généralement planes en matériau électriquement isolants sur lesquelles sont fixées lesdites bandes en matériau électriquement conducteur, cambrées à une seconde de leurs extrémités,

—les cambrures réalisées au niveau des secondes extrémités des bandes en matériau électriquement conducteur sont prévues sur un chant des plaques support généralement planes,

—les plaques support généralement planes s'étendent perpendiculairement au dispositif d'affichage statique et sont parallèles entre elles, et le système comprend en outre:

—une paroi de base généralement parallèle au dispositif d'affichage statique, sur laquelle sont fixées les plaques support par leur bord opposé au chant adjacent aux cambrures,

—une source lumineuse fixée sur la paroi de base, et

—des structures solidaires de la paroi des plaques support opposée à celle recevant les bandes en matériau électriquement conducteur, adaptées pour renvoyer vers le dispositif d'affichage la lumière émise par la source lumineuse.

L'établissement des contacts entre le dispositif d'affichage et le circuit pilote et le circuit d'alimentation électrique par l'intermédiaire de cambrures élastiques prévues sur les bandes électriquement conductrices, permet de garantir une interconnexion fiable avec le dispositif d'affichage statique d'une part et d'opérer une immobilisation ferme et précise de celui-ci, sans sollicitation excessive sur les plaques en verre de l'afficheur.

Par ailleurs, la disposition du circuit pilote de l'afficheur, c'est-à-dire du circuit générant les tensions de commande et de rafraîchissement de celui-ci, sur le support d'interconnexion, permet de limiter notablement le nombre de connexions à établir entre le support et les moyens d'alimentation électrique.

Cette disposition est particulièrement intéressante lorsque lesdites connexions sont réalisées sous forme soudées.

De préférence, l'un des bords du support porte des dentelures et les cambrures des bandes en matériau électriquement conducteur sont réalisées entre les dentelures.

Cette disposition permet notamment de protéger les zones des bandes en matériau électriquement conducteur destinées à être portées au contact du dispositif d'affichage.

La présente invention concerne également un procédé de fabrication du système précité qui comprend les étapes consistant:

i) à réaliser un réseau de bandes en matériau électriquement conducteur,

ii) à assurer l'assemblage du réseau de bandes sur une plaque support relativement rigide en matériau électriquement isolant par surmoulage, collage, soudure aux ultrasons ou bouterollage,

iii) à découper les bandes en matériau électriquement conducteur, au niveau de la zone d'implantation du circuit intégré pilote,

iv) à assurer la cambrure des extrémités des bandes situées sur un chant de la plaque support,

v) à implanter la pastille de circuit intégré servant de circuit pilote sur la plaque support,

vi) à placer la plaque support perpendiculairement au dispositif d'affichage statique pour porter les extrémités cambrées des bandes respectivement en appui contre les contacts associés du dispositif d'affichage, et

vii) à fixer ainsi la plaque support et le dispositif d'affichage.

Le circuit intégré est relié aux bandes en matériau électriquement conducteur selon des techniques connues en soi, telles que par exemple les techniques dites "Bonding", la technique de report à plat et soudure par refusion, on encore par l'intermédiaire de protubérances prévues au niveau des bornes du circuit intégré.

Le système précédemment défini peut trouver notamment application à la réalisation d'une boîte à lumière pour instrument indicateur, en particulier pour véhicules automobiles.

D'autres caractéristiques et avantages de la présente invention apparaîtront à la lecture de la description détaillée qui va suivre et en regard des dessins annexés donnés à titre d'exemple non limitatif et sur lesquels:

—la figure 1 représente une vue schématique en plan d'un dispositif d'interconnexion conforme à la présente invention,

—les figures 1a et 1b représentent des vues en coupe de détail d'un dispositif d'interconnexion selon un plan de coupe référence I—I sur la figure 1,

—la figure 2 représente une vue en plan d'un réseau de bandes en matériau électriquement conducteur intervenant dans la fabrication d'un dispositif d'interconnexion conforme à la présente invention,

—la figure 3 représente une vue de détail du dispositif d'interconnexion conforme à la présente invention au niveau de la zone d'implantation du circuit intégré,

—la figure 4 représente une vue en coupe transversale de la zone d'implantation d'un circuit intégré sur le support en matériau électriquement isolant, dans le cadre d'une technique de liaison du type "Bonding",

—la figure 5 illustre schématiquement les diverses étapes du procédé de fabrication conforme à la présente invention,

—la figure 6 illustre selon une vue en coupe transversale similaire à la figure 4, une variante de réalisation de la zone d'implantation du circuit intégré,

—la figure 7 illustre selon une vue en coupe transversale une troisième variante de réalisation de la zone d'implantation du circuit intégré,

—la figure 8 illustre également selon une vue en coupe transversale une quatrième variante de réalisation de la zone d'implantation du circuit intégré,

—la figure 9 représente une vue schématique en perspective d'une boîte à lumière conforme à la présente invention incorporant un dispositif d'interconnexion supportant un circuit pilote et une pluralité de bandes en matériau électriquement conducteur,

—la figure 10 représente une vue en coupe de la même boîte à lumière selon un plan de coupe référencé X—X sur la figure 9,

—la figure 11 représente une vue avant de la même boîte à lumière selon une vue référencée XI sur la figure 9,

—la figure 12 représente une vue latérale en bout de la même boîte à lumière selon une vue référencée XII sur la figure 11.

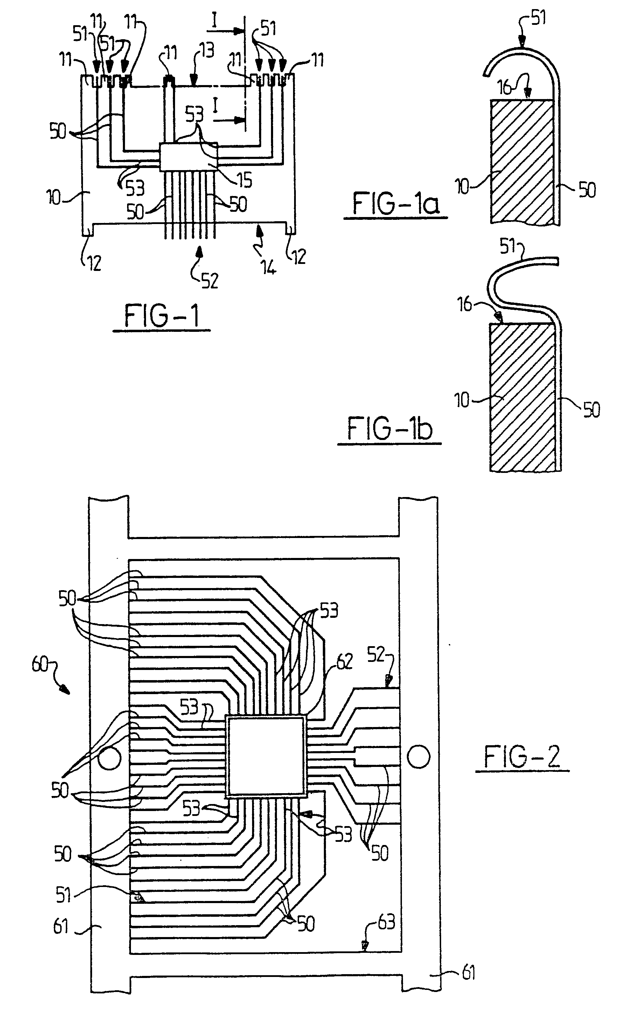

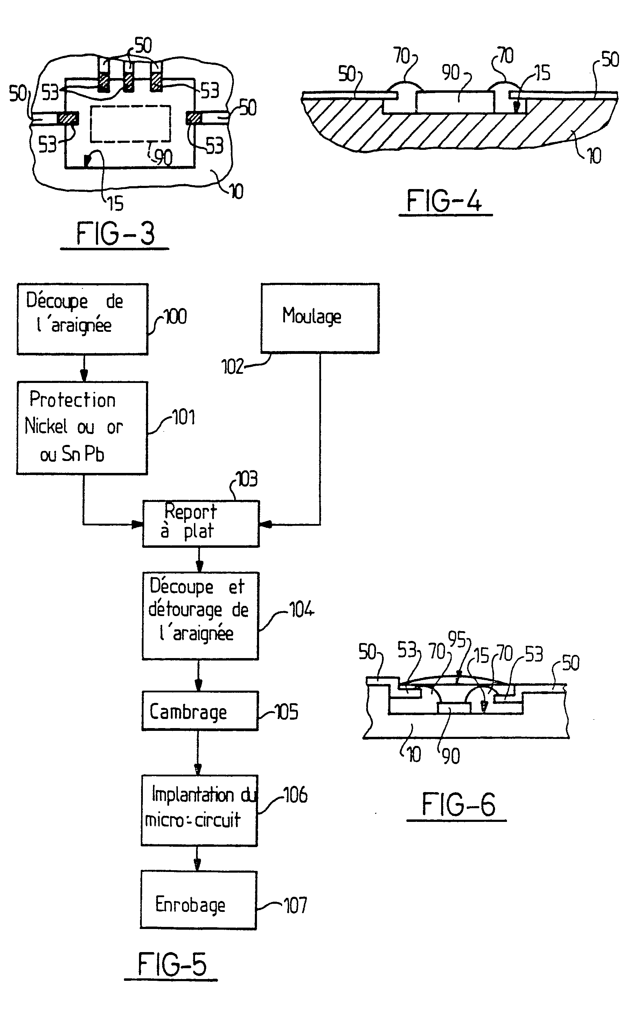

On aperçoit sur la figure 1 une plaque support 10 généralement plane en matériau électriquement isolant destinée à porter d'une part au moins un circuit intégré référencé 90 sur les figures 3, 4, 6, 7 et 8, d'autre part une série de bandes en matériau électriquement conducteur référencées 50 sur les figures.

Le matériau support électriquement isolant 10 est de préférence réalisé en plastique chargé tenant les températures classiques de soudure à la vague, par exemple en polyamide.

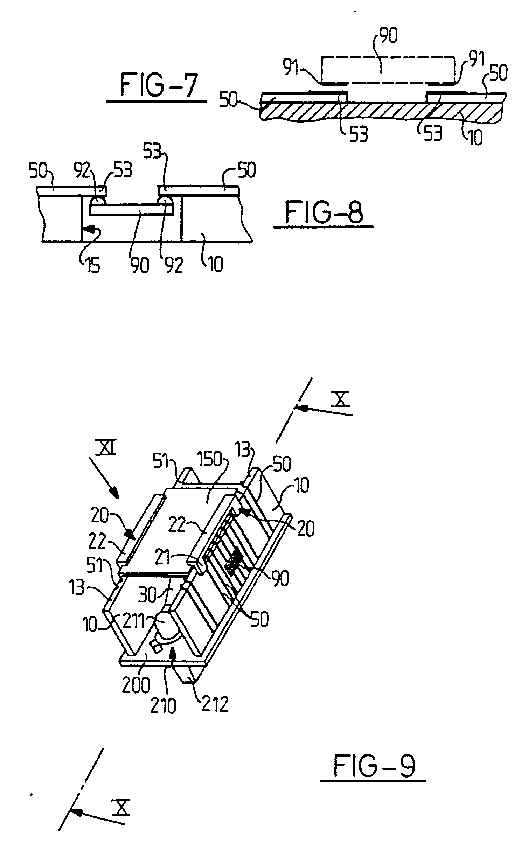

Les bandes en matériau électriquement conducteur 50 précitées sont adaptées pour relier entre eux le dispositif d'affichage (référencé 150 sur la figure 9), le circuit pilote 90 et le circuit d'alimentation (non représenté pour simplifier l'illustration).

Selon une caractéristique important de la présente invention, les contacts électriques établis entre le dispositif d'affichage 150 et les bandes conductrices 50 sont des contacts élastiques réalisés au niveau de cambrures 51 ménagées sur lesdites bandes 50.

Comme cela apparaît à l'examen des figures 1, 1a, 9 et 10, les cambrures 51 sont avantageusement réalisées au niveau d'extrémités des bandes 50 en matériau électriquement conducteur disposées sur le chant 16 du support 10, le dispositif d'affichage 150 et le support 10 étant à l'utilisation sensiblement perpendiculaires entre eux.

On a illustré sur les figures 1a et 1b deux modes de réalisation des cambrures 51.

Ces modes de réalisation, donnés à titre d'illustration, ne doivent cependant pas être considérés comme limitatifs.

Selon l'illustration des figures 1a et 1b, chaque cambrure 51 est formée d'une courbure en arc hémicirculaire convexe vers l'extérieur en direction de l'afficheur.

Comme illustré sur la figure 1, au niveau du bord rectiligne 13 adjacent au dispositif d'affichage 150, le support électriquement isolant 10 peut être muni de dentelures 11 entre lesquelles sont disposées les cambrures 51, afin en particulier de protéger celles-ci.

Bien entendu, afin de garantir un contact correct entre les cambrures 51 et les électrodes du dispositif d'affichage 150, il est nécessaire que la surface de contact des cambrures 51 dépasse les dentelures 11.

Sur la figure 1, la zone d'implantation des circuits intégrés 90 sur le support électriquement isolant 10 est référencée 15.

Les extrémités des bandes électriquement conductrices 50 destinées à être reliées aux bornes du circuit intégré 90 au niveau de la zone 15 sont référencées 53 sur la figure 1.

Par ailleurs, les extrémités des bandes électriquement conductrices 50 émergeant du support électriquement isolant 10 sur le bord 14 rectiligne de celui-ci opposé au bord 12 précité, sont référencées 52 sur la figure 1.

De préférence, le support électriquement isolant 10 comporte au niveau du bord rectiligne 14 précité des ergots 12 en saillie aptes à pénétrer dans une embase afin d'immobiliser mécaniquement le support 10 sur celle-ci.

On va maintenant décrire le procédé de fabrication d'un tel dispositif d'interconnexion en regard des figures 2 à 8.

Pour l'essentiel, ce procédé de fabrication utilise des techniques de réalisation et/ou d'implantation de circuit intégré connues en soi.

Comma cela est illustré schématiquement sur la figure 5 par l'étape référencée 100, la première phase du procédé consiste à réaliser un réseau 60 de bandes 50 en matériau électriquement conducteur, généralement dénommé "araignée", adaptées pour relier entre eux le dispositif d'affichage 150, le circuit pilote 90 et le circuit d'alimentation.

On remarquera à l'examen de la figure 1 que certaines de ces bandes 50 sont destinées à assurer une liaison électrique entre les électrodes du dispositif d'affichage 150 et le circuit pilote 90. L'une des extrémités de ces bandes 50 est munie d'une cambrure 51 précitée.

D'autres bandes 50 en matériau électriquement conducteur sont destinées à assurer une liaison électrique entre le circuit pilote 90 et le circuit d'alimentation électrique, par l'intermédiaire de leurs extrémités référencées 52 sur la figure 1.

Bien que cela ne soit pas représentée sur la figure 1 pour simplifier l'illustration, d'autres bandes 50 en matériau électriquement conducteur peuvent également être prévues sur le support 10 pour assurer une liaison directe entre le dispositif d'affichage 150 et les moyens d'alimentation électrique.

Bien entendu, de telles bandes 50 devraient être munies également de cambrures 51 à l'une de leurs extrémités.

Le cas échéant, l'extrémité 52 des bandes électriquement conductrices 50 peut également être munie de cambrures similaires aux cambrures 51 précitées.

On a représenté sur la figure 2 un exemple de réalisation d'un réseau de bandes électriquement conductrices intervenant dans la mise en oeuvre du procédé de fabrication conforme à la présente invention.

L'homme de l'art comprendra à l'examen de la figure 2 que de préférence, de tels réseaux de bandes électriquement conductrices 50 sont préparés selon les techniques classiques de réalisation de rubans pour mise en oeuvre du processus de "Transfert Automatique sur Bandes" dénommé couramment TAB.

Plus précisément, on aperçoit sur la figure 2 un réseau 60 de bandes électriquement conductrices 50 inscrites dans un cadre externe généralement rectangulaire 61, et reliées à celui-ci par l'intermédiaire de leurs extrémités 51, 52 correspondant respectivement aux extrémités de référence homologue illustrées sur la figure 1.

Les bandes électriquement conductrices 50 convergent par ailleurs vers un cadre interne 62 de forme carrée ou rectangulaire et sont reliées à celui-ci par leur extrémité 53 correspondant aux extrémités de références homologues illustrées sur la figure 1.

Plus précisément, le réseau 60 de bandes électriquement conductrices 50 illustrées sur la figure 2 peut être réalisé selon un processus consistant à:

—réaliser des perforations 63 correspondant aux fenêtres internes au cadre 61 précité, dans un film plastique en matériau électriquement isolant, par exemple un film en Mylar,

—à coller une feuille de cuivre sur le film plastique,

—à déposer une résine photosensible sur la couche de cuivre,

—à réaliser une insolation de celle-ci à travers un masque de géométrie appropriée, et

—à réaliser une gravure de la couche de cuivre selon toute technique de gravure connue en soi.

A titre d'exemple non limitatif:

—la fenêtre 63 peut présenter des dimensions de l'ordre de 35 mm sur 50 mm,

—la largeur des bandes électriquement conductrices 50 au niveau des extrémités 51 peut être de l'ordre de 0,40 mm et le pas des bandes de l'ordre de 1,60 mm,

—la largeur des bandes 50 au niveau des extrémités 52 peut être de l'ordre de 0,50 mm et le pas de l'ordre de 2,50 mm, tandis que

—la largeur des bandes 50 au niveau des extrémités 53 peut être de l'ordre de 0,3 mm et le pas des bandes de 1 mm.

Comme cela est illustré schématiquement sur la figure 5 par l'étape 101, le réseau 60 de bandes électriquement conductrices 50 ainsi réalisé doit être protégé, par exemple par dépôt d'une couche de protection à base de nickel ou d'or de l'ordre de 2 μ et de SnPb ou autres.

En parallèle, des étapes 100 et 101 précitées, il est nécessaire d'opérer le moulage du support électriquement isolant 10, tel qu'illustré à l'étape 102 sur la figure 5.

Comme indiqué précédemment, le support électriquement isolant 10 est de préférence réalisé en plastique chargé tenant les températures classiques de soudure à la vague, par exemple en polyamide.

Comme illustré à l'étape 103 sur la figure 5, le réseau 60 de bandes électriquement conductrices (dénommé couramment "araignée") est ensuite collé à plat sur le support électriquement isolant 10.

Comme on l'a mentionné précédemment, l'assemblage des bandes 50 sur le support 10 peut être fait selon diverses techniques tel que surmoulage, soudure aux ultrasons, bouterollage ou collage simple.

Comme illustré à l'étape 104 sur la figure 5, il faut ensuite découper le cadre interne 62 du réseau 60 afin de libérer les extrémités 53 des bandes électriquement conductrices 50 au niveau de la zone d'implantation du circuit intégré 90 et découper le cadre externe 61 sur la périphérie du support électriquement isolant 10.

L'étape ultérieure de fabrication consiste à assurer le cambrage des extrémités 51 des bandes électriquement conductrices 50, comme illustré schématiquement à l'étape 105 sur la figure 5.

Le support 10 est alors disponible pour recevoir la pastille du circuit intégré 90 comme illustré à l'étape 106 sur la figure 5.

Diverses techniques d'implantation de la pastille de circuit intégré 90 et de liaison de celle-ci avec les bandes 50 seront évoquées ultérieurement en regard des figures 3 à 8.

De préférence, comme cela est illustré sur la figure 5, la dernière étape du procédé de fabrication consiste à assurer un surmoulage d'une résine, par exemple en polyuréthane sur la pastille du circuit intégré 90.

Comme cela est illustré en particulier sur les figures 3, 4, 6 et 8, la zone 15 d'implantation de la pastille du circuit intégré 90 sur le support 10 peut être formée d'un renfoncement en creux.

La première technique d'implantation et de raccordement de la pastille du circuit intégré 90, représentée sur les figures 3 et 4, consiste à coller cette pastille 90 contre le fond de la cavité 15 puis de relier les bandes à cette pastille 90 aux extrémités 53 des bandes électriquement conductrices, par l'intermédiaire de fils 70 électriquement conducteurs, selon la technique classique dite de "Bonding".

Plus précisément, la pastille de circuit intégré 90 peut être reliée aux bandes 53 par l'intermédiaire de fils d'or 70 selon la technique de "ball bonding" ou à l'aide de fils d'aluminium 70 selon la technique de "Wedge bonding".

Ces techniques de soudure utilisent généralement des ultra-sons, l'une à une température comprise entre 150 et 180°, l'autre à température ambiante.

Selon une variante de réalisation de cette technique illustrée sur la figure 6, les extrémités 53 des bandes électriquement conductrices 50 peuvent être incurvées en direction du fond de la cavité 15 recevant la pastille du circuit intégré 90.

On a illustré schématiquement sur la figure 6 sous la référence 95 une couche de résine par exemple en polyuréthane surmoulée sur la pastille 90 de circuit intégré et la zone 15 d'implantation de celle-ci.

Une seconde technique de raccordement de la pastille de circuit intégré 90 est illustrée sur la figure 7.

Selon cette technique, les bornes de contact de la pastille 90 disposées sur une surface principale de celle-ci sont revêtues d'une couche d'étamage à base d'étain et/ou de plomb référencée 91 sur la figure 7.

De façon correspondante, les extrémités 53 des bandes 50 sont revêtues d'une couche d'étamage à base d'étain et de plomb. De plus, la géométrie des extrémités 53 est adaptée de telle sorte que celles-ci soient disposées en regard des bornes 91 de la pastille de circuit intégré.

Il suffit alors de disposer le circuit intégré en regard de la zone d'implantation 15, les bornes 91 étant en regard respectivement des extrémités 53 et d'assurer une soudure par refusion des zones d'étamage précitées pour raccorder la pastille du circuit imprimé 90 aux bandes électriquement conductrices 50.

Selon une autre technique de fabrication illustrée schématiquement sur la figure 8, la pastille de circuit intégré 90 peut être reliée aux extrémités 53 des bandes électriquement conductrices grâce à des protubérances 92 prévues sur les bornes de la pastille du circuit intégré.

Bien entendu, la présente invention n'est aucunement limitée aux techniques de raccordement précitées.

Comme on l'a précédemment évoqué, la présente invention trouve notamment application danu la réalisation de boîtes à lumière pous systèmes incorporant un dispositif d'affichage statique type écran plat.

Un exemple de réalisation d'une telle boîte à lumière est illustré sur les figures 9 à 12.

On aperçoit sur ces figures une paroi de base 200 sur laquelle sont fixés, d'un même côté et dans une position généralement parallèle, deux supports 10 généralement plans et relativement rigides, en matériau électriquement isolant, du type précité, qui porte une série de bandes 50 en matériau électriquement conducteur. L'un au moins des supports 10 porte de plus une pastille de circuit intégré 90 raccordée aux bandes 50.

L'immobilisation mécanique des supports 10 sur l'embase 200 est réalisée entre autre grâce aux ergots 12 ménagés sur le bord rectiligne 14 des supports.

De préférence, l'embase 200 est munie également de pistes électriquement conductrices raccordées aux extrémités 52 des bandes 50 par soudure.

Un dispositif d'affichage statique 150 type écran plat est posé sur le chant 13 des supports 10 et immobilisé sur celui-ci grâce à des étriers 20 articulés ou collés sur les supports 10 au voisinage du bord libre 13 des supports.

D'une façon générale, chaque étrier 20 comprend deux ailes orthogonales entre elles, destinées l'une 21 à être reliée au support 10, l'autre 22 à chevaucher le dispositif d'affichage 150 pour maintenir celui-ci en place.

La paroi de base 200 reçoit à une extrémité et entre les deux supports parallèles 10 précités, une source lumineuse 210.

De façon classique en soi, cette source lumineuse 210 peut être formée d'une lampe à filament ou d'une diode électroluminescente 211 logée dans un culot 212 immobilisé selon un montage à baïonnette sur la paroi de base 200, ou par tout moyen équivalent, tel que soudure à la vague.

Pour assurer un éclairage homogène, par l'arrière, du dispositif d'affichage 150, par exemple un afficheur à cristaux liquides, les supports 10 sont par ailleurs munis sur leurs surfaces opposées à celles recevant les bandes 50 de structures 30 formant réflecteur aptes à renvoyer vers le dispositif d'affichage 50 la lumière émise par la source lumineuse 210.

Plus précisément, de préférence, les structures 30 précitées forment un réflecteur d'allure parabolique et de section constante dans tout plan parallèle au plan des supports 10.

Ainsi, le réflecteur coopérant avec la source lumineuse 210 est avantageusement réalisé sous forme de deux éléments d'allure parabolique solidaires respectivement de la surface interne des supports 10 et raccordés selon un plan médian parallèle à ces derniers.

En variante, les structures 30 peuvent être de géométrie paraboloïdale, c'est-à-dire d'allure parabolique dans un plan parallèle aux supports et dans un plan transversal, perpendiculaire aux supports.

Une telle boîte à lumière convient en particulier pour la réalisation de montres digitales pour véhicules automobiles.

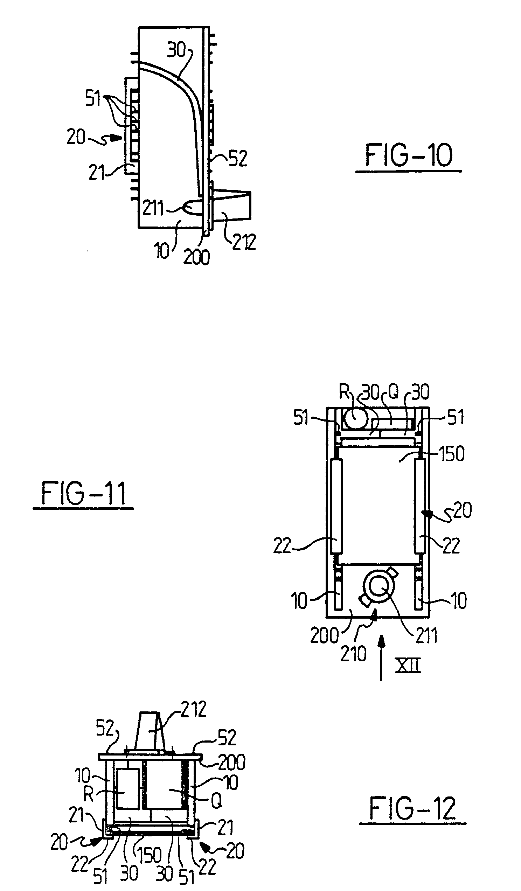

Dans un tel cas, la parois de base 200 peut être munie en arrière des structures formant réflecteur 30, soit à l'opposée de la source lumineuse 210 par rapport à ces structures, de composants discrets, tels qu'un quartz Q ou une résistance R illustré sur les figures 11 et 12, coopérant avec le circuit pilote de commande du dispositif d'affichage.

L'utilisation de structures 30 formant réflecteur sur l'une des faces du dispositif d'interconnexion 10 permet en particulier d'éliminer les systèmes optiques à effet de prisme généralement utilisés dans les dispositifs d'affichage à écran plat, en particulier dans les dispositifs d'affichage à cristaux liquides.

Bien entendu, la présente invention n'est aucunement limitée aux modes de réalisation particuliers qui viennent d'être décrits mais s'étend à toute variante conforme à son esprit.

Comme on l'aperçoit sur la figure 9, de préférence certaines des extrémités cambrées 51 des bandes 50, accessibles sur le chant du support 10, à côté de l'afficheur 150, et électriquement séparées au repos permettent, lorsqu'elles sont court-circuitées par un bouton poussoir, non représenté sur les figures pour simplifier l'illustration, d'introduire une information logique, telle que appel fonction ou une remise à l'heure.

Par ailleurs, on remarquera que les étriers 20 prévus sur les supports permettent, de façon classique en soi, de supporter en regard de l'afficheur proprement dit, différents organes annexes sous forme de feuille, tels que des filtres, polariseurs ou autres.

**Revendications**

1. Système afficheur du type comprenant:
   —un dispositif d'affichage statique type écran plat (150),
   —des moyens d'alimentation électrique comportant un circuit pilote pour le dispositif d'affichage, lequel circuit pilote est constitué d'une pastille de circuit intégré (90) et
   —un dispositif d'interconnexion (10) entre le dispositif d'affichage statique et les moyens d'alimentation électrique, lequel dispositif d'interconnexion comprend au moins une plaque support généralement plane en matériau relativement rigide et électriquement isolant, sur laquelle sont fixés la pastille du circuit intégré (90) ainsi qu'une série de bandes (50) en matériau électriquement conducteur, les contacts électriques de la pastille de circuit intégré, étant reliés respectivement à des premières extrémités des bandes en matériau électriquement conducteur, caractérisé par le fait que:
   —les bandes (50) en matériau électriquement conducteur sont prédécoupés dans une feuille puis fixées sur le support, et présentent à une seconde de leur extrémités des cambrures reposant contre les contacts respectivement associés du dispositif d'affichage,
   —le dispositif d'interconnexion (10) comprend au moins deux plaques généralement planes en matériau électriquement isolants sur lesquelles sont fixées lesdites bandes en matériau électriquement conducteur, cambrées à une seconde de leurs extrémités,
   —les cambrures (51) réalisées au niveau des secondes extrémités des bandes en matériau électriquement conducteur sont prévues sur un chant des plaques support généralement planes,
   —les plaques support (10) généralement plans s'étendent perpendiculairement au dispositif d'affichage statique et sont parallèles entre elles, et le système comprend en outre:
   —une paroi de base (200) généralement parallèle au dispositif d'affichage statique, sur laquelle sont fixées les plaques support par leur bord opposé au chant adjacent aux cambrures,
   —une source lumineuse (211) fixée sur la paroi de base, et
   —des structures (30) solidaires de la paroi des plaques support opposée à celle recevant les bandes en matériau électriquement conducteur, adaptées pour renvoyer vers le dispositif d'affichage la lumière émise par la source lumineuse.

2. Système afficheur selon la revendication 1, caractérisé par le fait que l'un des bords (13) des supports (10) porte des dentelures (11) et par le fait que les cambrures (51) des bandes (50) en matériau électriquement conducteur, sont réalisées entre les dentelures (11).

3. Procédé de fabrication du système afficheur conforme à l'une des revendications 1 à 2, caractérisé par le fait qu'il comprend les étapes consistant:
   i) à réaliser deux réseaux de bandes en matériau électriquement conducteur,
   ii) à assurer respectivement l'assemblage des réseaux (60) de bandes sur deux plaques support relativement rigides en matériau électriquement isolant par surmoulage, collage, soudure aux ultrasons ou bouterollage,
   iii) à découper les bandes en matériau électriquement conducteur de l'un des deux réseaux, au niveau de la zone d'implantation du circuit intégré pilote,
   iv) à assurer la cambrure des extrémités des bandes situées sur un chant de la plaque support,
   v) à implanter la pastille de circuit intégré servant de circuit pilote sur la plaque support,
   vi) à placer les plaques support perpendiculairement au dispositif d'affichage statique pour porter les extrémités cambrées des bandes respectivement en appui contre les contacts associés du dispositif d'affichage, et
   vii) à fixer ainsi les plaques support sur le dispositif d'affichage et sur une paroi de base généralement parallèle au dispositif d'affichage.

4. Procédé de fabrication selon la revendication 3, caractérisé par le fait que la pastille de circuit intégré (90) est reliée aux bandes (50) en matériau électriquement conducteur, selon la technique connue en soi dite de "Bonding".

5. Procédé de fabrication selon la revendication 3, caractérisé par le fait que la pastille de circuit intégré (90) est reliée aux bandes (50) en matériau électriquement conducteur, selon la technique connue en soi de report à plat et soudure pour refusion.

6. Procédé de fabrication selon la revendication 3, caractérisé par le fait que les bornes de la pastille intégrée comportent des protubérances (92) destinées à être portées en appui contre les bandes (50) en matériau électriquement conducteur respectivement associées.

**Patentansprüche**

1. Anschlußsystem derjenigen Art, die umfaßt:
—Eine statische Anschlußvorrichtung nach Art eines flachen Bildschirmes (150),
—Mittel zur elektrischen Energieversorgung, die eine Steuerschaltung für die Anschlußvorrichtung umfaßt, wobei die Steuerschaltung von einem Chip mit integrierter Schaltung (90) gebildet ist, und
—eine Verbindungseinrichtung (10) zwischen der statischen Anschlußvorrichtung und den Mitteln zur elektrischen Energieversorgung, wobei die Verbindungseinrichtung mindestens eine im wesentlichen ebene Halteplatte aus relativ starrem und elektrisch isolierendem Material umfaßt, auf der der Chip mit der integrierten Schaltung (90) sowie eine Reihe von Bändern (50) aus elektrisch leitendem Material befestigt sind, wobei die elektrischen Anschlüsse des Chips mit der integrierten Schaltung jeweils an den einen Enden der Bänder aus elektrisch leitendem Werkstoff angeschlossen sind,
dadurch gekennzeichnet, daß
—die Bänder (50) aus elektrisch leitendem Material vorher aus einer Folie ausgeschnitten sind, dann an der Halterung befestigt und an ihren anderen Enden gegen die jeweils zugehörigen Kontakte der Anschlußvorrichtung gebogen sind,
—die Verbindungseinrichtung (10) mindestens zwei im wesentlichen ebene Platten aus elektrisch isolierendem Material umfaßt, auf denen die Bänder aus elektrisch leitendem Material mit ihren anderen, umgebogenen Enden befestigt sind,
—die auf dem Niveau der anderen Enden der Bänder aus elektrisch leitendem Material ausgebildeten Umbiegungen (51) auf einer Kante der im wesentlichen ebenen Halteplatten vorgesehen sind,
—die im wesentlichen ebenen Halteplatten (10) sich senkrecht zu der statischen Anschlußvorrichtung und zueinander parallel erstrecken, und daß das System ferner umfaßt:
—eine im wesentlichen zu der statischen Anschlußvorrichtung parallele Basiswandung (200), auf der die Halteplatten mit ihren den Kanten in der Nachbarschaft der Umbiegungen gegenüberliegenden Rändern befestigt sind,
—eine Lichtquelle (211), die auf der Basiswandung befestigt ist,
—mit den Wänden der Halteplatten feste Strukturen (30),
welche gegenüber den Anschlüssen der Bänder aus elektrisch leitendem Material angeordnet und dazu ausgelegt sind, daß von der Lichtquelle emmittierte Licht gegen die Anschlußvorrichtung zu reflektieren.

2. Anschlußsystem nach Anspruch 1, dadurch gekennzeichnet, daß einer der Ränder (13) der Halterungen (10) Zahnungen (11) aufweist, und dadurch, daß die Umbiegungen (51) der Bänder (50) aus elektrisch leitendem Material zwischen den Zahnungen (11) ausgebildet sind.

3. Verfahren zum Herstellen des Anschlußsystems nach einem der Ansprüche 1 bis 2, dadurch gekennzeichnet, daß es folgende Schritte aufweist:

i) Ausbilden zweier Stränge Bänder aus elektrisch leitendem Material,

ii) jeweils Sicherstellen des Anbringens der Stränge (60) Bänder auf den beiden relativ festen Halteplatten aus elektrisch isolierendem Material durch Gießen, Kleben, Ultraschall-Schweißen oder Nieten,

iii) Schneiden der Bänder aus elektrisch leitendem Material einer der beiden Stränge in der Höhe des Gebietes des Einsatzes der integrierten Steuerschaltung,

iv) Sicherstellen der Umbiegung der Enden der Bänder an einer Kante der Halteplatte,

v) Aufbringen des Chips mit der integrierten Schaltung, die als Steuerschaltung dient, auf die Halteplatte,

vi) Anordnen der Halteplatte senkrecht zu der statischen Anschlußvorrichtung zum Bringen der umgebogenen Enden der Bänder in Anlage an die zugeordneten Kontakte der Anschlußvorrichtung, und

vii) Befestigen der Halteplatten auf der Anschlußvorrichtung und auf einer im wesentlichen zu der Anschlußvorrichtung parallelen Basiswandung.

4. Herstellungsverfahren nach Anspruch 3, dadurch gekennzeichnet, daß der Chip mit der integrierten Schaltung (90) an die Bänder (50) aus elektrisch leitendem Material mittels des bekannten "Bondens" angeschlossen wird.

5. Herstellungsverfahren nach Anspruch 3, dadurch gekennzeichnet, daß der Chip mit der integrierten Schaltung (90) an die Bänder (50) aus elektrisch leitendem Material angeschlossen ist, und zwar mittels des bekannten Aufbringens auf die Ebene und Einschmelzschweißens.

6. Herstellungsverfahren nach Anspruch 3, dadurch gekennzeichnet, daß die Anschlußstifte des integrierten Chips Protuberanzen (92) aufweisen, die dazu bestimmt sind, gegen die jeweils zugeordneten Bänder (50) aus elektrisch leitendem Material gedrückt zu werden.

**Claims**

1. Display system of the type comprising:
—a flat screen-type static display device (150),
—electrical supply means including a control circuit for the display device, this control circuit being in the form of an integrated circut chip (90) and
—a device (10) for interconnection between the static display device and the electrical supply means, this interconnection device comprising at least one generally plane support plate of relatively inflexible and electrically insulating material, on which there are fixed the integrated circuit chip (90) and a series of strips (50) of electrically conductive material, the electrical contacts of the integrated circuit chip being respectively connected to first ends of the strips of electrically conductive material, characterized in that:

—the strips (50) of electrically conductive material are cut out previously from a sheet and then fixed on the support, and have at a second end curved sections resting against the respectively associated contacts of the display device,

—the interconnection device (10) comprises at least two generally plane plates of electrically insulating material, on which there are fixed the said strips of electrically conductive material, curved at a second end,

—the curved sections (51) made in the location of the second ends of the strips of electrically conductive material are provided on one edge of the generally plane support plates,

—the generally plane support plates (10) extend perpendicular to the static display device and are parallel to one another, and the system furthermore comprises:

—a base wall (200) which is generally parallel to the static display device and on which the support plates are fixed by means of their edge side opposite the edge adjacent to the curved sections,

—a light source (211) fixed on the base wall, and

—structures (30) integral with the wall of the support plates opposite that receiving the strips of electrically conductive material, adapted to redirect the light emitted by the light source back towards the display device.

2. Display system according to Claim 1, characterized in that one of the edge sides (13) of the supports (10) has indentations (11), and in that the curved sections (51) of the strips (50) of electrically conductive material are made between the indentations (11).

3. Process for manufacturing the display system according to one of Claims 1 to 2, characterized in that it comprises steps consisting in:

i) forming two networks of strips of electrically conductive material,

ii) respectively assembling the networks (60) of strips on two relatively inflexible support plates of electrically insulating material by overmoulding, gluing, ultrasound sealing or snap riveting,

iii) cutting the strips of electrically conductive material out of one of the two networks, at the location of mounting the control integrated circuit,

iv) curving the ends of the strips on one edge of the support plate,

v) mounting the integrated circuit chip, serving as a control circuit, on the support plate,

vi) bringing the support plates perpendicular to the static display device in order to bring the curved ends of the strips to bear respectively against the associated contacts of the display device, and

vii) thus fixing the support plates on the display device and on one base wall which is generally parallel to the display device.

4. Manufacturing process according to Claim 3, characterized in that the integrated circuit chip (90) is connected to the strips (50) of electrically conductive material by the technique, known per se, called "bonding".

5. Manufacturing process according to Claim 3, characterized in that the integrated circuit chip (90) is connected to the strips (50), of electrically conductive material by the technique, known per se, of flat attachment and refusion welding.

6. Manufacturing process according to Claim 3, characterized in that the terminals of the integrated chip have protuberances (92) intended to be brought to bear against the respectively associated strips (50) of electrically conductive material.

FIG-1

FIG-1a

FIG-1b

FIG-2

FIG-3

FIG-4

FIG-5

| Découpe de l'araignée | 100 |
| Protection Nickel ou or ou Sn Pb | 101 |
| Moulage | 102 |
| Report à plat | 103 |
| Découpe et détourage de l'araignée | 104 |
| Cambrage | 105 |
| Implantation du micro-circuit | 106 |
| Enrobage | 107 |

FIG-6

2

FIG-7

FIG-8

FIG-9

FIG-10

FIG-11

FIG-12